# EUROPÄISCHE PATENTANMELDUNG

(11) **EP 3 000 911 A1**
(43) Veröffentlichungstag der Anmeldung: **30.03.2016**
(21) Anmeldenummer: 14003357.2
(22) Anmeldetag: 29.09.2014
(51) Int. Cl.: C23C 14/00, B22F 1/00, B32B 7/06, C09C 1/00, C09C 1/62, C09C 1/64

(54) **Verfahren zur Herstellung eines Metallpigment-Mehrschichtpakets**

(71) Anmelder: Schlenk Metallic Pigments GmbH, 91154 Roth (DE)
(72) Erfinder: Rinck, Joachim, 91126 Schwabach (DE); Reiter, Andreas, 21423 Hoopte (DE); Weinberg, Maria, 91186 Büchenbach (DE); Kuntz, Matthias, 64342 Seeheim-Jugenheim (DE)
(74) Vertreter: Müller-Boré & Partner Patentanwälte PartG mbB

(57) **Zusammenfassung**

Die vorliegende Erfindung betrifft ein Verfahren zur Herstellung eines Metallpigment-Mehrschichtpakets mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten (I) ist, umfassend die Schritte:
(a) Bereitstellen einer Trägerfolie,
(b) Aufbringen einer Releasecoatschicht (II), dessen Material unterschiedlich von den weiteren im Metallpigment-Mehrschichtpaket vorgesehenen Releasecoatschichten (I) ist,
(c) abwechselndes Aufbringen von Metallschichten und Releasecoatschichten (I) auf die Releasecoatschicht (II), so dass darauf ein Stapel aus Metallschichten und Releasecoat-Schichten (I) gebildet wird, worin die Metallschichten und Releasecoat-Schichten (I) abwechselnd mit insgesamt (2n + 1) (n≥1, bevorzugt n≥3, mehr bevorzugt n≥5) Schichten aufeinander angeordnet sind, wobei die innerste und die äußerste Schicht dieses Stapels Metallschichten sind, und
(d) Abtrennen des Metallpigment-Mehrschichtpakets mit dem Stapel aus Metallschichten und Releasecoat-Schichten (I) auf der Releasecoatschicht (II) von der Trägerfolie.

## Beschreibung

Die vorliegende Erfindung betrifft ein Verfahren zur Herstellung eines Metallpigment-Mehrschichtpakets mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten (I) ist.

Metall-, insbesondere Aluminiumplättchen werden herkömmlicherweise in einer Kugelmühle, welche Stahlkugeln, Aluminiummetall, ein Gemisch aus Aliphaten und Aromaten ("Testbenzin") und eine Fettsäure, die üblicherweise von Stearinsäure oder Ölsäure abgeleitet ist, enthält. Die Stahlkugeln glätten das Aluminium und zerbrechen es zu Plättchen. Wenn der Kugelmühlvorgang fertig ist, wird die Masse durch ein Maschensieb geleitet, um die Partikel nach Größen aufzuteilen. Plättchen, die zu groß sind, um durch das Sieb hindurch zu passen, werden zur weiteren Bearbeitung zu der Kugelmühle rückgeführt. Plättchen mit der richtigen Größe werden durch das Sieb hindurchgeleitet und in eine Filterpresse eingeführt, in der überschüssiges Lösungsmittel von den Plättchen abgetrennt wird. Der Filterkuchen wird anschließend abgelassen. Solche herkömmlichen Aluminiumplättchen weisen typischerweise eine Größe von 2 bis etwa 200 µm und eine Partikeldicke von ungefähr 0,1 bis 2,0 µm auf. Diese Plättchen sind in der Regel durch eine hohe diffuse Reflektion, eine niedrige Spektralreflektion, eine rauhe ungleichmäßige Plättchenmikrooberfläche und ein relativ niedriges Aspektverhältnis gekennzeichnet.

Unter metallischen PVD Pigmenten versteht man sehr dünne Pigmente (< 100 nm), mit denen es möglich ist, in konventionellen, wässrigen und UV vernetzbarenDruck-, Lack- oder anderen Polymersystemen spiegelartige Effekte zu erzeugen. Der Herstellungsprozeß dieser Pigmente basiert auf dem PVD-Prozeß (physical vapour deposition), bei dem Metalle oder Metallverbindungen im Hochvakuum verdampft und in sehr dünnen Schichten wieder abgeschieden werden.

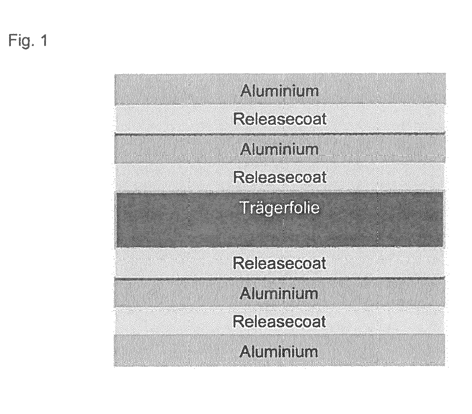

Ein Verfahren zur Herstellung von solchen Metallplättchen ist insofern ein Verfahren, worin beide Seiten eines Polyesterträgers mit einer auf Lösungsmittel basierenden Harzlösung (Releasecoat) tiefdruckbeschichtet werden. Die getrocknete beschichtete Bahn wird anschließend zu einer metallisierenden Einrichtung transportiert, in der beide Seiten der beschichteten Folie durch einen Dünnfilm aus aufgedampftem Aluminium metallisiert werden. Die Folie mit dem dünnen Metallfilm wird dann zu der Beschichtungseinrichtung zurückgebracht, in der beide Seiten des Aluminiums mit einem zweiten Film der auf Lösungsmittel basierenden Harzlösung (Releasecoat) beschichtet werden. Die getrocknete beschichtete Metallfolie wird dann wiederum zu der metallisierenden Einrichtung transportiert, um einen zweiten Film von aufgedampftem Aluminium auf beide Seiten der Folie aufzubringen (vgl. Figur 1). Die resultierende Mehrschichtfolie wird anschließend zur weiteren Bearbeitung zu einer Einrichtung transportiert, worin die Beschichtungen in einem Lösungsmittel wie beispielsweise Aceton von dem Träger abgezogen werden, d.h. die mit Releasecoat und Aluminium beschichtete Folie durchläuft ein Lösemittelbad, in dem der Releasecoat aufgelöst und die Aluminiumschicht letztlich in Form grober Partikel dispergiert wird. Der so erhaltene Filterkuchen kann verschiedene Waschschritte und Lösungsmittelaustauschschritte durchlaufen und wird dann als Dispersion auf die gewünschte Partikelgröße zerkleinert. Im gesamten Verfahren muss darauf geachtet werden, dass die sehr dünnen Partikel nicht zu hoch aufkonzentriert werden, da sie sonst agglomerieren; typischerweise werden max. 20%ige lösemittelhaltige Dispersionen vertrieben.

Um die Ausbeute im Ablöseschritt zu erhöhen und die Kosten für die relativ teure Trägerfolie zu erniedrigen, arbeitet man typischerweise mit mehreren Schichten alternierend zwischen Releasecoat und Aluminium. Typisch sind bis zu 6 Aluminiumschichten pro Seite der Trägerfolie (vgl. Figur 1). Im Ablösevorgang werden dann alle Schichten mehr oder weniger gleichzeitig an- und abgelöst. Dieses Verfahren birgt jedoch die folgenden Probleme:
- Alle verwendeten Releasecoats müssen sehr gut löslich sein, um ein schnelles Ablösen in den aufwendig konzipierten Ablösebädern zu gewährleisten;
- das Pigment muss immer in einer Suspension gehalten werden. Falls Ablöselösemittel und Anwendungslösemittel unterschiedlich sind, muss aufwendig das Lösemittel ausgetauscht werden;
- die Zerkleinerung der Pigmente muss in Suspension erfolgen, was die Möglichkeiten der Feinst- und Grobanteil-Abtrennung etc. limitiert und sich negativ auf die Qualität der Pigmente auswirkt.

Der vorliegenden Erfindung liegt somit die Aufgabe zugrunde, die Anzahl der Herstellungsschritte und die resultierenden Kosten zur Herstellung solcher reflektierenden PVD-erzeugten Metallplättchen wie z.B. Aluminiumplättchen zu reduzieren.

Diese Aufgabe wird durch die in den Ansprüchen gekennzeichneten Ausführungsformen gelöst.

Insbesondere wird ein Verfahren zur Herstellung eines Metallpigment-Mehrschichtpakets mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten (I) ist, bereitgestellt, umfassend die Schritte:
(a) Bereitstellen einer Trägerfolie,
(b) Aufbringen einer Releasecoatschicht (II), dessen Material unterschiedlich von den weiteren im Metallpigment-Mehrschichtpaket vorgesehenen Releasecoatschichten (I) ist,
(c) abwechselndes Aufbringen von Metallschichten und Releasecoatschichten (I) auf die Releasecoatschicht (II), so dass darauf ein Stapel aus Metallschichten und Releasecoat-Schichten (I) gebildet wird, worin die Metallschichten und Releasecoat-Schichten (I) abwechselnd mit insgesamt (2n + 1) (n≥1, bevorzugt n≥3, mehr bevorzugt n≥5) Schichten aufeinander angeordnet sind, wobei die innerste und die äußerste Schicht dieses Stapels Metallschichten sind, und
(d) Abtrennen des Metallpigment-Mehrschichtpakets mit dem Stapel aus Metallschichten und Releasecoat-Schichten (I) auf der Releasecoatschicht (II) von der Trägerfolie.

In einer bevorzugten Ausführungsform umfasst das erfindungsgemäße Verfahren nach Schritt (c) bzw. vor Schritt (d):
(b') das Wiederholen des Aufbringens einer Releasecoatschicht (II) auf der äußersten Metallschicht des in Schritt (c) erzeugten ersten Stapels,
(c') das Wiederholen des abwechselnden Aufbringens von Metallschichten und Releasecoatschichten (I) auf der in Schritt (b') aufgebrachten Releasecoatschicht (II), so dass darauf ein zweiter Stapel aus Metallschichten und Releasecoat-Schichten (I) gebildet wird, worin die Metallschichten und Releasecoat-Schichten (I) abwechselnd mit insgesamt (2n + 1) (n≥1, bevorzugt n≥3, mehr bevorzugt n≥5) Schichten aufeinander angeordnet sind, so daß der erste und zweite Stapel durch eine Releasecoatschicht (II) voneinander getrennt sind.

Besonders bevorzugt werden die Schritte (b') und (c') jeweils getrennt nacheinander iterativ m-fach (m ≥3) durchgeführt.

Aus Gründen eines gewünschten Aspektverhältnisses bei der späteren Zerkleinerung, können also auch mehrere Zwischenschichten von Releasecoat (II) eingebracht werden, so dass z.B. jede 10te Releasecoat-Schicht vom Typ (II) ist und sich bei n=30 drei Schichtpackete à 10 Schichten ablösen.

Das erfindungsgemäße Verfahren arbeitet nach dem Prinzip, dass im ersten Ablösevorgang nur die Schicht zwischen Trägerfolie und erster Metallschicht, insbesondere Aluminiumschicht, abgelöst wird, der Rest der Schichtpackte aber zunächst als Packet, in welchem die Metallschichten und Releasecoatschichten (I) jeweils sandwichartig übereinandergestapelt sind, erhalten bleibt.

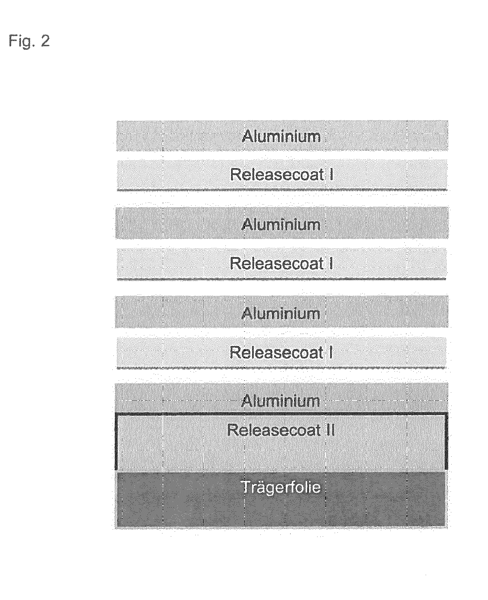

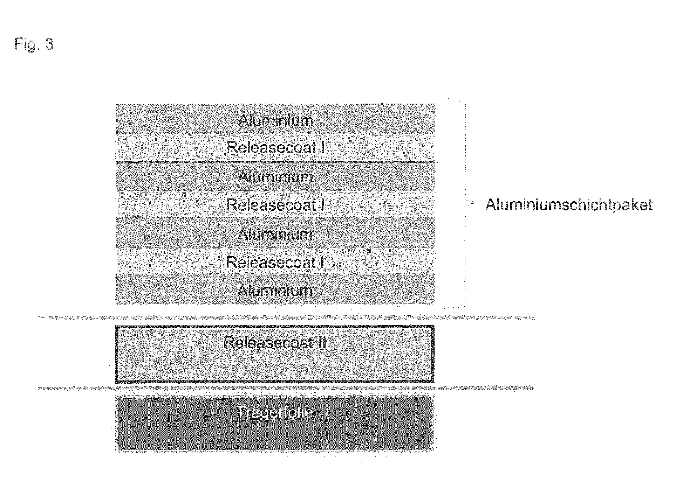

Im erfindungsgemäß vorgesehenen Schichtaufbau wird mit zwei verschiedenen Releasecoat-Systemen gearbeitet. Releasecoat (II) wird im ersten Ablöseschritt aufgelöst oder von der Trägerfolie abgetrennt. Dabei bleiben Schichtpackete, bestehend aus Metallschichten und Releasecoat (I)-Schichten, als solche erhalten (vgl. Figuren 2 und 3).

Die Separierung des Metallschicht- bzw. Aluminiumschichtpackets als in sich geschlossene Schicht ist durch folgende Vorgehensweisen möglich:
i. Releasecoat (II) wird zusammen mit dem Metallschicht- bzw. Aluminiumschichtpacket von der Trägerfolie mechanisch abgetrennt, z.B. durch entsprechende Verfahren mittels Umlenken der Trägerfolie in einem spitzen Winkel, Einbringen von Temperatur, Druckluft oder Flüssigkeitsstrahl, Spannungsveränderungen der Trägerfolie, etc.. Hierzu ist es nicht zwingend notwendig, dass sich Releasecoat (I) und (II) chemisch unterscheiden.
ii. Ablösen des Releasecoats (II) in einem Lösemittel, das Releasecoat (I) nicht anlöst, d.h. man arbeitet mit zwei unterschiedlichen Releasecoats. Es ist hierbar auch möglich, mit Wasser zu arbeiten, da beispielsweise das ansonsten mit Wasser reagierende Aluminium in dem vorhandenen Schichtaufbau des Aluminiumschichtpackets relativ gut geschützt ist.

Das Abtrennen des Metallpigment-Mehrschichtpakets mit dem Stapel aus Metallschichten und Releasecoat-Schichten (I) von der Trägerfolie mit der Releasecoatschicht (II) kann durch Unterschiede in der Glasübergangstemperatur oder dem Schmelzpunkt, durch unterschiedliche Löslichkeit von Releasecoat (I) und (II) in verschiedenen Lösemitteln, durch unterschiedliche Löslichkeit von Releasecoat (I) und (II) bei verschiedenen Temperaturen, durch unterschiedliche Dicke von Releasecoat (II) verglichen mit Releasecoat (I) oder durch unterschiedliche Haftung von Releasecoat (II) zu Trägermaterial und Metallpigment erreicht werden. Der Releasecoat (II) und Releasecoat (I) könnnen insofern chemisch unterschiedlich oder identisch sein.

In einer bevorzugten Ausführungsform der vorliegenden Erfindung unterscheiden sich die Materialen der Releasecoat-Schichten (I) und (II) in mindestens einer der folgenden Eigenschaften:
(i) das Material der Releasecoat-Schicht (II) weist eine Glasübergangstemperatur T_{g} (II) und das Material der Releasecoat-Schicht (I) eine Glasübergangstemperatur T_{g} (I) derart auf, dass die Differenz der Glasübergangstemperaturen T_{g} (II) und T_{g} (I) mindestens größer als 10°C, vorzugsweise mindestens größer als 15°C, mehr bevorzugt mindestens 20°C, ist; oder
(ii) das Material der Releasecoat-Schicht (II) weist einen Schmelzpunkt Tₛ (II) und das Material der Releasecoat-Schicht (I) einen Schmelzpunkt Tₛ (I) derart auf, dass die Differenz der Schmelzpunkte Tₛ (II) und Tₛ (I) mindestens größer als 10°C, vorzugsweise mindestens größer als 15°C, mehr bevorzugt mindestens 20°C, ist, oder
(iii) die Releasecoat-Schicht (II) und die Releasecoat-Schicht (I) sind dergestalt, dass sich beide Schichten in unterschiedlichen Lösemitteln lösen, deren Löslichkeitsparameter (nach Hansen) δ_{d}, δₚ oder δₕ sich um 0,2 MPa oder mehr, vorzugsweise 1 MPa oder mehr, mehr bevorzugt 1,5 MPa oder mehr unterscheiden.

Im Rahmen der vorliegenden Erfindung können auch Systeme mit Releasecoatschichten (I) und (II) vorgesehen werden, die chemisch analog bzw. gleich sind, aber unterschiedliche Schichtstärken aufweisen, worüber Unterschiede im Anlöseverhalten erzeugt werden.

In einer anderen Ausführungsform kann die Löslichkeit von Releasecoat (II) in einem Lösemittel bei niedriger Temperatur und die Löslichkeit von Releasecoat (I) in einem Lösemittel bei einer höheren Temperatur als Releasecoat-Schicht (II) gegeben sein, wobei die Differenzen der Temperaturen 15°C oder mehr betragen.

In noch einer anderen Ausführungsform kann die Löslichkeit von Releasecoat (II) in einem Lösemittel bei hoher Temperatur und die Löslichkeit von Releasecoat-Schicht (I) bei einer niedrigeren Temperatur als Releasecoat (II) gegeben sein, wobei die Differenzen der Temperaturen 15°C oder mehr betragen.

Schließlich kann auch die Haftung von Releasecoat (II) zu dem Trägermaterial schlechter als die Haftung zum Metall sein bzw. kann die Haftung von Releasecoat (I) zum Metall besser als die Haftung von Releasecoat (II) zum Trägermaterial sein.

Das Material der Releasecoat-Schichten (I) und (II) unterliegt keiner wesentlichen Beschränkung und wird vorzugsweise aus Acrylaten, Cellulosederivaten (z.B. Celluloseacetobutyrate [CABs], Cellulosenitraten [Nitrocellulose], Celluloseacetopropionaten [CAPs], Celluloseacetaten), Lacksystemen vernetzt mittels Ultraviolett- (UV) Strahlung, Keton- und Aldehydharzen, Polystyrolen und Copolymerisaten des Styrols, Polyvinylalkoholen, Polyvinylbutyralen, Kohlenwasserstoffharzen, Fetten, Wachsen, Amido- und Aminoharzen, Polyestern, Alkyden, Epoxiden, Phenolharzen, Polyamiden, Polyurethanen, Polyvinylchloriden, Polyolefinen, halogenierten Polyolefinen, Polyvinylestern, Polyvinylacetalen, Polyvinylethern, Polyvinylpyrrolidonen und Gemischen davon ausgewählt.

Beispielhafte Releasecoat-Kombinationen/systeme sind wie folgt:
- CAB Harz mit zweitem CAB Harz, wobei ein CAB Harz in polaren und das andere in unpolaren Lösemitteln löslich ist; z.B. CAB 551-0.01 mit CAB 553-0.4 oder CAB 551-0.01 mit CAB 381-0.5 oder Solus 2100 mit Solus 3050 oder Solus 2300 mit Solus 3050.
- Acrylatharz mit zweitem Acrylatharz, wobei ein Acrylatharz in polaren und das andere in unpolaren Lösemitteln löslich ist; z.B. Elvacite 2669 mit Elvacite 2028 oder Elvacite 2669 mit Degalan LP 67/11 oder NeoCryl B 813 / 817 / 818 / 890 mit Degalan LP 67/11.
- CAB Harz mit Acrylatharz, wobei das CAB Harz in unpolaren und das Acrylatharz in polaren Lösemitteln löslich ist; z.B. CAB 551-0.01 mit Elvacite 2669 oder CAB 551-0.01 mit NeoCryl B 813 / 817 / 818 / 890 oder Solus 2100 / 2300 mit Elvacite 2669 oder Solus 2100 / 2300 mit NeoCryl B 813 / 817 / 818 / 890.
- CAB Harz mit Acrylatharz, wobei das CAB Harz in polaren und das Acrylatharz in unpolaren Lösemitteln löslich ist; z.B. CAB 553-0.4 mit Elvacite 2028 oder CAB 553-0.4 mit Degalan LP 67/11 oder Solus 3050 mit Elvacite 2028 oder Solus 3050 mit Degalan LP 67/11. Vorzugsweise werden CABs, CAPs und Acrylatharze eingesetzt.

Im Rahmen des erfindungsgemäßen Verfahrens werden die Metallschichten üblicherweise mittels PVD-Verfahren oder Sputtern aufgebracht, vorzugsweise so daß die Metallschichten jeweils Schichtdicken im Bereich von 6 bis 250 nm, vorzugsweise 10 bis 100 nm, aufweisen. Als Metalle können insbesondere Aluminium, Kupfer, Kupferlegierung, Cu-Zn oder Silber eingesetzt werden, welche insbesondere mittels PVD-Verfahren aufgebracht werden. Besonders bevorzugt ist Aluminium.

Als Trägerfolienmaterial können die auf diesem Fachgebiet üblicherweise eingesetzten vorgesehen werden, z.B. PET-Folien, etc.

Die Releasecoatschichten (I) werden in der Regel mittels Druckverfahren oder Bedampfung im Hochvakuum aufgebracht, vorzugsweise so daß die Releasecoat-Schichten jeweils Schichtdicken im Bereich von 10 bis 500 nm, vorzugsweise 50 bis 300 nm, aufweisen. Die Releasecoatschichten (II) werden üblicherweise ebenso mittels Druckverfahren oder Bedampfung im Hochvakuum aufgebracht, vorzugsweise so daß die Releasecoat-Schicht(en) eine Schichtdicke im Bereich von 10 bis 1500 nm, vorzugsweise 100 bis 850 nm, aufweist bzw. aufweisen.

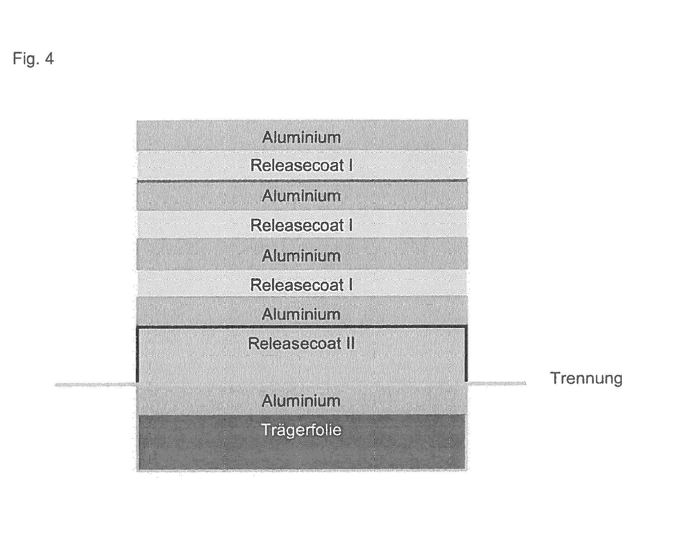

In einer weiteren Ausführungsform der vorliegenden Erfindung kann vor dem Aufbringen der Releasecoatschicht (II) auf der Trägerfolie in Schritt (a) zunächst auf der Trägerfolie eine Metallschicht vorgesehen werden, worauf dann die Releasecoatschicht (II) abgeschieden wird; vgl. Figur 4. Wird die Trägerfolie direkt mit Metall bedampft, so kann in bestimmten Ausführungsformen der Releasecoat (II) leichter entfernt werden. Zusätzlich kann die Trägerfolie so geschützt werden, dass sie eventuell wiederverwendet werden kann, so daß die Kosten des Herstellungsprozesses weiter gesenkt werden können.

Das erfindungsgemäße Verfahren kann weiter den Schritt des Mahlens des Metallpigment-Mehrschichtpakets umfassen. Schließlich kann ferner der Schritt des Suspendierens des Metallpigment-Mehrschichtpakets, vorzugsweise derart, daß die resultierende Pigmentsuspension auf einen Anteil von 40 Gew.-% oder höher, bezogen auf Metallfestköper, eingestellt ist, vorgesehen werden.

Die nachfolgend aufgezählten Vorteile des erfindungsgemäßen Verfahrens ergeben sich im Wesentlichen daraus, dass im Unterschied zu herkömmlichen, eingangs beschriebenen Verfahren im erfindungsgemäßen Verfahren ein Metallschichtpacket komplett abgelöst wird, das bei einer beispielhaften Schichtfolge von 8 Metall- bzw. Aluminiumschichten(n) plus 7 entsprechende Releasecoat (I) Schichten (n-1) im Bereich von ca. 0,5 bis 5 µm liegt und die Metall- bzw. Aluminiumschichten, die nicht außen liegen, geschützt sind. Damit lassen sich folgende wesentlichen Vorteile realisieren:
1. Im Falle einer mechanischen Abtrennung (d.h. lösemittelfrei) liegt sofort ein stabiles weiterverarbeitbares Pigment vor, das nicht agglomeriert. Dieses Pigment kann trocken prozessiert werden, d.h. auf die richtige Größe gemahlen werden und von Über- oder Unterkorn im Trockenen befreit werden, z.B. durch Sichtung oder andere Methoden. Die komplette Infrastruktur für Ablösebäder und Austauschung von Lösemittel entfällt. Das so vorbereitete Pigment/Aluminiumschichtpacket kann dann in einem Lösemittel der Wahl in einem einfachen Rührbehälter in das Endprodukt, d.h. Pigmente aus den einzelnen Aluminiumschichten (10-100 nm) überführt werden. Lagerung und Transport können in der trockenen Form erfolgen, es entstehen erhebliche Einsparungen in der Prozessierung, dem Transport und den Gefahrguteinstufungen (Dispersion in LM versus Pulver). Die Vorteile dieses Verfahrens gelten analog auch, wenn der Releasecoat II mit Lösungsmittel entfernt werden muss. Durch den Mehrschichtaufbau des Aluminiumpacketes kann die abgelöste Suspension getrocknet werden und im Trockenen analog, wie vorstehend beschrieben, weiter verarbeitet werden.
2. Durch die Verwendung von unterschiedlichen Releasecoat (I) und Releasecoat (II) ist man nicht mehr von der Ablösegeschwindigkeit des Releasecoat (I) abhängig, da das Auflösen dieser Zwischenschichten später in einem Rührkessel erfolgt, und dieser Vorgang keinesfalls zeitkritisch ist. Damit kann man beliebige Systeme für den Releasecoat (I) verwenden, was immense Vorteile bei der Gestaltung des Endproduktes beinhaltet. Bei dem PVD Verfahren bleiben immer gewisse Mengen Releasecoat im Endprodukt, d.h. der Pigmentdispersion. Da diese Dispersion in verschiedensten Endanwendungen im Druck-, Lack- und Masterbatch-Bereich eingesetzt werden, kommt es immer wieder zu Unverträglichkeiten oder Viskositätsproblemen. Mit dem erfindungsgemäßen Verfahren können jetzt alle beliebigen Releasecoat-Systeme verwendet werden, und damit Unverträglichkeiten vermieden werden. Zudem können Konzentration und Endlösemittel sehr individuell auf Kundensysteme angepasst werden, da beliebige Mengen der trockenen Metall- bzw. Aluminiumschichtpackete ganz einfach in kleinen Gefäßen mit beliebigen Lösemitteln in beliebigen Konzentrationen aufgelöst werden können.
3. Für die Weiterverarbeitung von mechanisch oder mit Lösungsmittel abgelösten Schichtpacketen zu Pigmenten mit Multischichten, z.B. Mahlung und Klassierung, gibt es für die Anzahl der Schichten eine Begrenzung, die durch ein Aspektverhältnis gegeben ist, die sich aus der Größe des Pigmentes in x-y-Richtung und der Dicke ergibt. Beispielsweise ergibt sich bei einer Schichtabfolge von n=10 (Releasecoat 200 nm, Aluminium 30 nm) nach n = Aluminium, n-1 = Releasecoat eine Gesamtdicke des Partikels von 2,1 µm. Bei einem D₅₀ von 20 µm wäre das Aspektverhältnis ca. 1:10. Da Effektpigmente in ihren Anwendungen in der Regel im Bereich D₅₀ von 3 - 50 µm liegen, und das Aspektverhältnis im Bereich von 1: 10 oder höher liegen sollte, machen für die Bereitstellung von Pigmenten, die aus mehreren Schichten bestehen, nur Schichtaufbauten bis zu 50-100 Schichten Sinn. Diese können mit dem erfindungsgemäßen Verfahren besonders wirtschaftlich hergestellt werden.

In einem weiteren Aspekt der vorliegenden Erfindung wird ein Metallpigment-Mehrschichtpaket mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten ist, bereitgestellt. Vorzugsweise weist ein solches Metallpigment-Mehrschichtpaket eine laterale (xy) Ausdehnung von 3 bis 50 µm, vorzugsweise von 5 bis 50 µm, auf und das Aspektverhältnis (xy/z) beträgt 5 :1 oder höher, vorzugsweise 10 : 1 oder höher. Das Material der Metallschichten ist dabei unabhängig voneinander in der Regel aus Aluminium, Kupfer, Kupferlegierung, Cu-Zn oder Silber, vorzugsweise aus Aluminium, ausgewählt.

Das erfindungsgemäße Verfahren zeichnet sich schließlich noch durch folgende Aspekte aus:
- alle genannten Schichtaufbauten und Systeme können auf beiden Seiten der Trägerfolie angebracht werden, das spart Kosten der Trägerfolie und erhöht die Ausbeute;
- das erfindungsgemäße Verfahren beschränkt sich nicht nur auf Metalle, sondern kann auf alle Materialien angewendet werden, die gesputtert oder aufgedampft werden können. Dies können Metalle, aber auch Metalloxide, Polymere, oder andere anorganische Materialien sein;
- die Chemie der möglichen Releasecoats ist unbeschränkt, auch das Aufbringen des Releasecoats; neben allen gängigen Druckverfahren ist auch Bedampfen oder Besputtern direkt im Hochvakuum-Metallizer zugänglich, um Prozeßkosten zu sparen;
die Trägerfolie kann aus allen möglichen Materialien bestehen, z.B. Polymere, aber auch Metallfolien sind denkbar; grundsätzlich könnte auch ohne dedizierte Trägerfolie gearbeitet werden, z.B. mit einen Band oder Walze, das kontinuierlich bedruckt/bedampft wird und bei dem die Schichten kontinuierlich abgelöst werden.

## Patentansprüche

1. Verfahren zur Herstellung eines Metallpigment-Mehrschichtpakets mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten (I) ist, umfassend die Schritte:
(a) Bereitstellen einer Trägerfolie,
(b) Aufbringen einer Releasecoatschicht (II), dessen Material unterschiedlich von den weiteren im Metallpigment-Mehrschichtpaket vorgesehenen Releasecoatschichten (I) ist,
(c) abwechselndes Aufbringen von Metallschichten und Releasecoatschichten (I) auf die Releasecoatschicht (II), so dass darauf ein Stapel aus Metallschichten und Releasecoat-Schichten (I) gebildet wird, worin die Metallschichten und Releasecoat-Schichten (I) abwechselnd mit insgesamt (2n + 1) (n≥1, bevorzugt n≥3, mehr bevorzugt n≥5) Schichten aufeinander angeordnet sind, wobei die innerste und die äußerste Schicht dieses Stapels Metallschichten sind, und
(d) Abtrennen des Metallpigment-Mehrschichtpakets mit dem Stapel aus Metallschichten und Releasecoat-Schichten (I) auf der Releasecoatschicht (II) von der Trägerfolie.

2. Verfahren gemäß Anspruch 1, wobei die Materialen der Releasecoat-Schichten (I) und (II) sich in mindestens einer der folgenden Eigenschaften unterscheiden:
(i) das Material der Releasecoat-Schicht (II) weist eine Glasübergangstemperatur T_{g} (II) und das Material der Releasecoat-Schicht (I) eine Glasübergangstemperatur T_{g} (I) derart auf, dass die Differenz der Glasübergangstemperaturen T_{g} (II) und T_{g} (I) mindestens größer als 10°C ist; oder
(ii) das Material der Releasecoat-Schicht (II) weist einen Schmelzpunkt Tₛ (II) und das Material der Releasecoat-Schicht (I) einen Schmelzpunkt Tₛ (I) derart auf, dass die Differenz der Schmelzpunkte Tₛ (II) und Tₛ (I) mindestens größer als 10°C ist, oder
(iii) die Releasecoat-Schicht (II) und die Releasecoat-Schicht (I) sind dergestalt, dass sich beide Schichten in unterschiedlichen Lösemitteln lösen, deren Löslichkeitsparameter (nach Hansen) δ_{d}, δₚ oder δₕ sich um 0,2 MPa oder mehr, vorzugsweise 1 MPa oder mehr, mehr bevorzugt 1,5 MPa oder mehr unterscheiden.

3. Verfahren gemäß Anspruch 1 oder 2, weiter umfassend nach Schritt (c) bzw. vor Schritt (d):
(b') das Wiederholen des Aufbringens einer Releasecoatschicht (II) auf der äußersten Metallschicht des in Schritt (c) erzeugten ersten Stapels,
(c') das Wiederholen des abwechselnden Aufbringens von Metallschichten und Releasecoatschichten (I) auf der in Schritt (b') aufgebrachten Releasecoatschicht (II), so dass darauf ein zweiter Stapel aus Metallschichten und Releasecoat-Schichten (I) gebildet wird, worin die Metallschichten und Releasecoat-Schichten (I) abwechselnd mit insgesamt (2n + 1) (n≥1, bevorzugt n≥3, mehr bevorzugt n≥5) Schichten aufeinander angeordnet sind, so daß der erste und zweite Stapel durch eine Releasecoatschicht (II) voneinander getrennt sind.

4. Verfahren gemäß Anspruch 3, wobei die Schritte (b') und (c') jeweils getrennt nacheinander iterativ m-fach (m ≥3) durchgeführt werden.

5. Verfahren gemäß einem der Ansprüche 1 bis 4, wobei die Metallschichten mittels PVD-Verfahren oder Sputtern aufgebracht werden, vorzugsweise so daß die Metallschichten jeweils Schichtdicken im Bereich von 6 bis 250 nm, vorzugsweise 10 bis 100 nm, aufweisen.

6. Verfahren gemäß einem der Ansprüche 1 bis 5, wobei die Releasecoatschichten (I) mittels Druckverfahren oder Bedampfung im Hochvakuum aufgebracht werden, vorzugsweise so daß die Releasecoat-Schichten jeweils Schichtdicken im Bereich von 10 bis 500 nm, vorzugsweise 50 bis 300 nm, aufweisen.

7. Verfahren gemäß einem der Ansprüche 1 bis 6, wobei die Releasecoatschichten (II) mittels Druckverfahren oder Bedampfung im Hochvakuum aufgebracht werden, vorzugsweise so daß die Releasecoat-Schichten jeweils Schichtdicken im Bereich von 10 bis 1500 nm, vorzugsweise 100 bis 850 nm, aufweisen.

8. Verfahren gemäß einem der Ansprüche 1 bis 7, wobei vor dem Aufbringen der Releasecoatschicht (II) auf der Trägerfolie in Schritt (a) zunächst auf der Trägerfolie eine Metallschicht vorgesehen wird, worauf dann die Releasecoatschicht (II) abgeschieden wird.

9. Verfahren gemäß einem der Ansprüche 1 bis 8, wobei das Material der Releasecoat-Schichten (I) und (II) aus Acrylaten, Cellulosederivaten (z.B. Celluloseacetobutyrate [CABs], Cellulosenitraten [Nitrocellulose], Celluloseacetopropionaten [CAPs], Celluloseacetaten), Lacksystemen vernetzt mittels Ultraviolett (UV)-Strahlung, Keton- und Aldehydharzen, Polystyrolen und Copolymerisaten des Styrols, Polyvinylalkoholen, Polyvinylbutyralen, Kohlenwasserstoffharzen, Fetten, Wachsen, Amido- und Aminoharzen, Polyestern, Alkyden, Epoxiden, Phenolharzen, Polyamiden, Polyurethanen, Polyvinylchloriden, Polyolefinen, halogenierten Polyolefinen, Polyvinylestern, Polyvinylacetalen, Polyvinylethern, Polyvinylpyrrolidonen und Gemischen davon ausgewählt wird.

10. Verfahren gemäß einem der Ansprüche 1 bis 9, weiter umfassend den Schritt des Mahlens des Metallpigment-Mehrschichtpakets.

11. Verfahren gemäß einem der Ansprüche 1 bis 10, weiter umfassend den Schritt des Suspendierens des Metallpigment-Mehrschichtpakets, vorzugsweise derart, daß die resultierende Pigmentsuspension auf einen Anteil von 40 Gew.- % oder höher, bezogen auf Metallfestköper, eingestellt ist.

12. Metallpigment-Mehrschichtpaket mit mindestens einem Stapel aus Metallschichten und Releasecoat-Schichten (I), die abwechselnd mit insgesamt (2n + 1) (n≥1, bevorzugt n≥3, mehr bevorzugt n≥5) Schichten aufeinander angeordnet sind, wobei die innerste und die äußerste Schicht Metallschichten sind, wobei unter der innersten Metallschicht eine weitere Releasecoatschicht (II) vorliegt, dessen Material unterschiedlich von den anderen im Metallpigment-Mehrschichtpaket vorliegenden Releasecoatschichten ist.

13. Metallpigment-Mehrschichtpaket gemäß Anspruch 12, wobei das Metallpigment-Mehrschichtpaket eine laterale (xy) Ausdehnung von 3 bis 50 µm, vorzugsweise von 5 bis 50 µm, aufweist und das Aspektverhältnis (xy/z) 5 :1 oder höher, vorzugsweise 10 : 1 oder höher beträgt.

14. Metallpigment-Mehrschichtpaket gemäß Anspruch 12 oder 13, wobei das Material der Metallschichten unabhängig voneinander aus Aluminium, Kupfer, Kupferlegierung, Cu-Zn oder Silber, vorzugsweise aus Aluminium, ausgewählt ist.
